(19) Europäisches Patentamt
European Patent Office
Office européen des brevets

(11) **EP 2 176 892 B1**

(12) **EUROPEAN PATENT SPECIFICATION**

(45) Date of publication and mention
of the grant of the patent:
**27.09.2017 Bulletin 2017/39**

(21) Application number: **08776564.0**

(22) Date of filing: **03.07.2008**

(51) Int Cl.:
*H01L 33/20* (2010.01)    *H01L 33/50* (2010.01)
*C09K 11/77* (2006.01)    *C04B 35/44* (2006.01)
*C04B 35/584* (2006.01)    *C04B 35/597* (2006.01)
*B82Y 20/00* (2011.01)    *H01L 33/00* (2010.01)
*H01L 33/10* (2010.01)    *H01L 33/60* (2010.01)
*H01S 5/10* (2006.01)    *H01S 5/343* (2006.01)
*C04B 35/64* (2006.01)    *C04B 35/626* (2006.01)

(86) International application number:
**PCT/IB2008/052687**

(87) International publication number:
**WO 2009/016529 (05.02.2009 Gazette 2009/06)**

(54) **LIGHT EMITTING DEVICE INCLUDING A PHOTONIC CRYSTAL, A LIGHT VALVE AND A LUMINESCENT CERAMIC**

**LICHTEMITTIERENDE VORRICHTUNG MIT PHOTONENKRISTALL, LICHTVENTIL UND LUMINESZENTER KERAMIK**

**DISPOSITIF ÉLECTROLUMINESCENT COMPRENANT UN CRISTAL PHOTONIQUE, UNE VALVE POUR LUMIÈRE ET UNE CÉRAMIQUE LUMINESCENTE**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.07.2007 US 829799**

(43) Date of publication of application:
**21.04.2010 Bulletin 2010/16**

(73) Proprietors:
• **Koninklijke Philips N.V.**
 **5656 AE Eindhoven (NL)**
• **Philips Lumileds Lighting Company LLC**
 **San Jose, CA 95131 (US)**

(72) Inventors:
• **WIERER, JR, Jonathan J.**
 **San Jose, CA 95131 (US)**
• **BIERHUIZEN, Serge**
 **San Jose, CA 95131 (US)**

• **DAVID, Aurelien J. F.**
 **San Jose, CA 95131 (US)**
• **KRAMES, Michael R.**
 **San Jose, CA 95131 (US)**
• **WEISS, Richard J.**
 **San Jose, CA 95131 (US)**

(74) Representative: **Rüber, Bernhard Jakob**
 **Lumileds Germany GmbH**
 **Intellectual Property**
 **Philipsstraße 8**
 **52068 Aachen (DE)**

(56) References cited:
**US-A- 6 155 699**     **US-A1- 2004 145 308**
**US-A1- 2004 206 972**     **US-A1- 2005 023 545**
**US-A1- 2005 205 883**     **US-A1- 2005 224 826**
**US-A1- 2005 269 582**

EP 2 176 892 B1

**EP 2 176 892 B1**

**Description**

FIELD OF INVENTION

The present invention relates to semiconductor light emitting devices including a photonic crystal, a light-valve and a luminescent ceramic.

BACKGROUND

This is a continuation-in-part of U.S. Application Serial No. 10/861,172, filed June 3, 2004 by Gerd O. Mueller et al., titled "Luminescent Ceramic for a Light Emitting Device", and published as US 2005/0269582 A1 on December 8, 2005.

Light emitting diodes (LEDs) are well-known solid state devices that can generate light having a peak wavelength in a specific region of the light spectrum. LEDs are typically used as illuminators, indicators and displays. Traditionally, the most efficient LEDs emit light having a peak wavelength in the red region of the light spectrum, i.e., red light. However, III-nitride LEDs have been developed that can efficiently emit light having a peak wavelength in the UV to green region of the spectrum. III-nitride LEDs can provide significantly brighter output light than traditional LEDs.

In addition, since light from III-nitride devices generally has a shorter wavelength than red light, the light generated by the III-nitride LEDs can be readily converted to produce light having a longer wavelength. It is well known in the art that light having a first peak wavelength (the "primary light") can be converted into light having a longer peak wavelength (the "secondary light") using a process known as luminescence/fluorescence. The fluorescent process involves absorbing the primary light by a wavelength-converting material such as a phosphor, exciting the luminescent centers of the phosphor material, which emit the secondary light. The peak wavelength of the secondary light will depend on the phosphor material. The type of phosphor material can be chosen to yield secondary light having a particular peak wavelength.

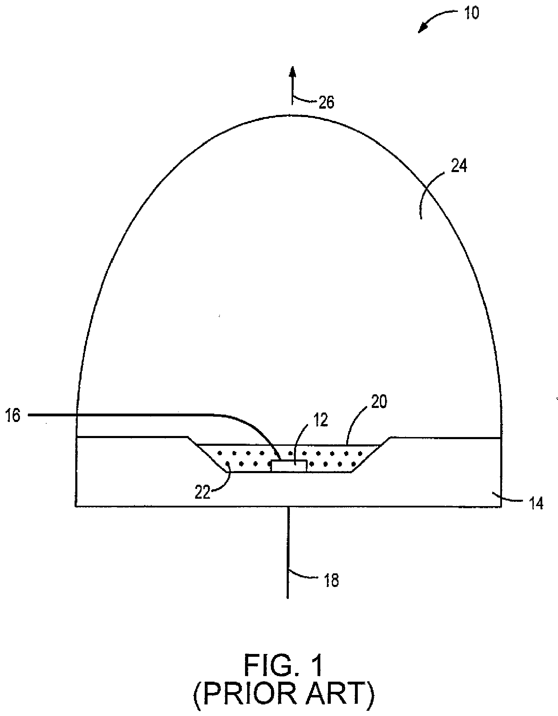

With reference to FIG. 1, a prior art phosphor LED 10 described in U.S. Patent 6,351,069 is shown. The LED 10 includes a III-nitride die 12 that generates blue primary light when activated. The III-nitride die 12 is positioned on a reflector cup lead frame 14 and is electrically coupled to leads 16 and 18. The leads 16 and 18 conduct electrical power to the III-nitride die 12. The III-nitride die 12 is covered by a layer 20, often a transparent resin, that includes wavelength-converting material 22. The type of wavelength-converting material utilized to form the layer 20 can vary, depending upon the desired spectral distribution of the secondary light that will be generated by the fluorescent material 22. The III-nitride die 12 and the fluorescent layer 20 are encapsulated by a lens 24. The lens 24 is typically made of a transparent epoxy or silicone.

In operation, electrical power is supplied to the III-nitride die 12 to activate the die. When activated, die 12 emits the primary light away from the top surface of the die. A portion of the emitted primary light is absorbed by the wavelength-converting material 22 in the layer 20. The wavelength-converting material 22 then emits secondary light, i.e., the converted light having a longer peak wavelength, in response to absorption of the primary light. The remaining unabsorbed portion of the emitted primary light is transmitted through the wavelength-converting layer, along with the secondary light. The lens 24 directs the unabsorbed primary light and the secondary light in a general direction indicated by arrow 26 as output light. Thus, the output light is a composite light that is composed of the primary light emitted from die 12 and the secondary light emitted from the wavelength-converting layer 20. The wavelength-converting material may also be configured such that very little or none of the primary light escapes the device, as in the case of a die that emits UV primary light combined with one or more wavelength-converting materials that emit visible secondary light.

As III-nitride LEDs are operated at higher power and higher temperature, the transparency of the organic encapsulants used in layer 20 tend to degrade, undesirably reducing the light extraction efficiency of the device and potentially undesirably altering the appearance of the light emitted from the device. Several alternative configurations of wavelength-converting materials have been proposed, such as growth of LED devices on single crystal luminescent substrates as described in U.S. Patent 6,630,691, thin film phosphor layers as described in U.S. Patent 6,696,703, and conformal layers deposited by electrophoretic deposition as described in U.S. Patent 6,576,488 or stenciling as described in U.S. Patent 6,650,044. However, one major disadvantage of prior solutions is the optical heterogeneity of the phosphor/encapsulant system, which leads to scattering, potentially causing losses in conversion efficiency. US 2004/0145308 A1 relates to light sources (1) having at least one LED (2) for emitting primary radiation (4) and at least one luminescence conversion body (3) having at least one luminescent material for converting the primary radiation (4) into secondary radiation (5). The luminescence conversion body is a polycrystalline ceramic body comprising, for example, a luminescent material based on a cerium-doped yttrium aluminum garnet (YAG:Ce). Blue primary radiation and yellow secondary radiation penetrate through the luminescence conversion body and are perceived as white light.

US 2004/0206972 A1 discloses a photonic crystal patterned blue LED (300) having a layer (180) containing a phosphor material, typically YAG for broad yellow emission, disposed on the LED's surface in order to emit mixed light, perceived as white light.

US 2005/0205883 A1 discloses a photonic crystal structure (122) formed in an n-type region (108) of a III-nitride semiconductor structure including an active region (112) sandwiched between n-type (108) and p-type (116) regions. A reflector is formed on a surface of the p-type region opposite the active region. The photonic crystal and reflector form a resonant cavity, which allows control of light emitted by the active region.

US 2005/0224826 A1 discloses a light emitting device including an LED (300), a concentrator element (302), such as a compound parabolic concentrator, a filter (354), such as a dichroic filter, and a wavelength converting layer (352), such as a phosphor layer.

SUMMARY OF INVENTION

In accordance with the present invention, a device according to claim 1 is defined. The device comprises a semiconductor structure including a light emitting layer disposed between an n-type region and a p-type region and a photonic crystal formed within or on a surface of the semiconductor structure, combined with a ceramic layer which is disposed in a path of light emitted by the light emitting layer. The ceramic layer is composed of or includes a wavelength converting material such as a phosphor. A light valve is further disposed between the semiconductor structure and the ceramic layer. The variation in refractive index due to the photonic crystal is configured to emit light in a predetermined angular emission profile. The light valve is configured to transmit a majority of light emitted in the predetermined emission profile and incident on the light valve. The dependent claims 2-12 define further advantageous embodiments of the present invention.

BRIEF DESCRIPTION OF THE DRAWINGS

Fig. 1 illustrates a prior art phosphor-converted semiconductor light emitting device, as known from US 6,351,069 B1.

Fig. 2 illustrates a flip chip semiconductor light emitting device including a ceramic phosphor layer, as also known from US 2005/0269582 A1.

Fig. 3 illustrates a semiconductor light emitting device including a bonded host substrate and a ceramic phosphor layer, as also known from US 2005/0269582 A1.

Fig. 4 illustrates an example of a doping profile in a ceramic phosphor layer, as known likewise from US 2005/0269582 A1.

Fig. 5 illustrates a semiconductor light emitting device including multiple ceramic layers, as also known from US 2005/0269582 A1.

Fig 6 illustrates a semiconductor light emitting device including a shaped ceramic phosphor layer, as also known from US 2005/0269582 A1.

Fig. 7 illustrates a semiconductor light emitting device, as known likewise from US 2005/0269582 A1, including a ceramic phosphor layer wider than the epitaxial layers in the device.

Fig. 8 illustrates a semiconductor light emitting device, as also known from US 2005/0269582 A1, including a ceramic phosphor layer and a heat extraction structure.

Fig. 9 is a cross sectional view of an example, as also known from US 2005/0205883 A1, of a photonic crystal light emitting device lacking a growth substrate.

Fig. 10 is a plan view of the device of Fig. 9.

Fig. 11 illustrates an alternative example, also known from US 2005/0205883 A1.

Figs. 12A-12D are cut away plan views of the device of Fig. 11.

Fig 13 is a plan view of a photonic crystal structure comprising a planar lattice of holes, as also known from US 2005/0205883 A1.

Fig. 14 illustrates a method, also known likewise from US 2005/0205883 A1, of fabricating the device of Fig. 9.

Fig. 15 illustrates an epitaxial structure prior to bonding to a host substrate, as also known from US 2005/0205883 A1.

Fig. 16 illustrates a method of bonding an epitaxial structure to a host substrate, as known likewise from US 2005/0205883 A1.

Fig 17 illustrates a method of removing a sapphire substrate from a III-nitride epitaxial structure, as also known from US 2005/0205883 A1.

Fig. 18 illustrates photoelectrochemical etching to thin the epitaxial layers after growth substrate removal, as known likewlse from US 2005/0205883 A1.

Figs. 19-22 illustrate a method, also known from US 2005/0205883 A1, of forming a photonic crystal structure.

Figs. 23A and 23B illustrate a method, known likewise from US 2005/0205883 A1, of forming a photonic crystal structure.

Fig. 24 illustrates a device including a light valve and luminescent ceramic spaced apart from a semiconductor structure including a photonic crystal.

Fig. 25 illustrates a device including a light valve and luminescent ceramic adhered to a semiconductor structure including a photonic crystal.

Fig. 26 illustrates a device including a light valve, luminescent ceramic, and lens spaced apart from a semiconductor structure including a photonic crystal.

Fig. 27 illustrates a device including a light valve and luminescent ceramic shaped as a lens spaced apart from a semiconductor structure including a photonic crystal.

Fig. 28 illustrates a device including a light valve and luminescent ceramic spaced apart by a lens from a semiconductor structure including a photonic crystal.

Fig. 29 illustrates a device including a light valve and luminescent ceramic separated by a lens and connected to a semiconductor structure including a photonic crystal.

Fig. 30 is a plot of transmission percent vs. wavelength for light striking a light valve at several incident angles.

Fig. 31 illustrates a narrow radiation pattern, emitted for example from a semiconductor light emitting device including a photonic crystal.

Fig. 32 illustrates a Lambertian radiation pattern, emitted for example from a semiconductor light emitting device including a rough surface.

Fig. 33 is a plot of transmission percent vs. wavelength for light striking a light valve from a Lambertian light source and from a narrow radiation pattern source.

Fig. 34 is a plot of transmission percent vs. wavelength for light striking a light valve from several light sources which emit light in various narrow radiation patterns.

DETAILED DESCRIPTION

The above-mentioned devices with thin film or conformal phosphor layers can be difficult to handle because the phosphor layers tend to be fragile. In accordance with embodiments of the invention, wavelength converting materials such as phosphors are formed into ceramic slabs, referred to herein as "luminescent ceramics." The ceramic slabs are generally self-supporting layers formed separately from the semiconductor device, then attached to the finished semiconductor device or used as a growth substrate for the semiconductor device. The ceramic layers may be translucent or transparent, which may reduce the scattering loss associated with non-transparent wavelength converting layers such as conformal layers. Luminescent ceramic layers may be more robust than thin film or conformal phosphor layers. In addition, since luminescent ceramic layers are solid, it may be easier to make optical contact to additional optical elements such as lenses and secondary optics, which are also solid.

Examples of phosphors that may be formed into luminescent ceramic layers include aluminum garnet phosphors with the general formula $(Lu_{1-x-y-a-b}Y_xGd_y)_3(Al_{1-z}Ga_z)_5O_{12}:Ce_aPr_b$ wherein $0 < x < 1$, $0 < y < 1$, $0 < z \leq 0.1$, $0 < a \leq 0.2$ and $0 < b \leq 0.1$, such as $Lu_3Al_5O_{12}:Ce^{3+}$ and $Y_3Al_5O_{12}:Ce^{3+}$ which emit light in the yellow-green range; and $(Sr_{1-x-y}Ba_x-Ca_y)_{2-z}Si_{5-a}Al_aN_{8-a}O_a:Eu_z^{2+}$ wherein $0 \leq a < 5$, $0 < x \leq 1$, $0 \leq y \leq 1$, and $0 < z \leq 1$ such as $Sr_2Si_5N_8:Eu^{2+}$, which emit light in the red range. Suitable $Y_3Al_5O_{12}:Ce^{3+}$ ceramic slabs may be purchased from Baikowski International Corporation of Charlotte, NC. Other green, yellow, and red emitting phosphors may also be suitable, including $(Sr_{1-a-b}Ca_b-Ba_c)Si_xN_yO_z:Eu_a^{2+}$ (a = 0.002 - 0.2, b = 0.0 - 0.25, c = 0.0 - 0.25, x = 1.5 - 2.5, y = 1.5 - 2.5, z = 1.5 - 2.5) including, for example, $SrSi_2N_2O_2:Eu^{2+}$; $(Sr_{1-u-v-x}Mg_uCa_vBa_x)(Ga_{2-y-z}Al_yIn_zS_4):Eu^{2+}$ including, for example, $SrGa_2S_4:Eu^{2+}$; $Sr_{1-x}Ba_xSiO_4:Eu^{2+}$; and $(Ca_{1-x}Sr_x)S:EU^{2+}$ wherein $0 < x \leq 1$ including, for example, $CaS:Eu^{2+}$ and $SrS:Eu^{2+}$.

A luminescent ceramic may be formed by heating a powder phosphor at high pressure until the surface of the phosphor particles begin to soften and melt. The partially melted particles stick together to form a rigid agglomerate of particles. Unlike a thin film, which optically behaves as a single, large phosphor particle with no optical discontinuities, a luminescent ceramic behaves as tightly packed individual phosphor particles, such that there are small optical discontinuities at the interface between different phosphor particles. Thus, luminescent ceramics are optically almost homogenous and have the same refractive index as the phosphor material forming the luminescent ceramic. Unlike a conformal phosphor layer or a phosphor layer disposed in a transparent material such as a resin, a luminescent ceramic generally requires no binder material (such as an organic resin or epoxy) other than the phosphor itself, such that there is very little space or material of a different refractive index between the individual phosphor particles. As a result, a luminescent ceramic is transparent or translucent, unlike a conformal phosphor layer.

Luminescent ceramic layers may be attached to light emitting devices by, for example, wafer bonding, sintering, gluing with thin layers of known organic adhesives such as epoxy or silicone, gluing with high index inorganic adhesives, and gluing with sol-gel glasses.

Examples of high index adhesives include high index optical glasses such Schott glass SF59, Schott glass LaSF 3, Schott glass LaSF N18, and mixtures thereof. These glasses are available from Schott Glass Technologies Incorporated, of Duryea, Pa. Examples of other high index adhesives include high index chalcogenide glass, such as (Ge,Sb,Ga)(S,Se) chalcogenide glasses, III-V semiconductors including but not limited to GaP, InGaP, GaAs, and GaN, II-VI semiconductors including but not limited to ZnS, ZnSe, ZnTe, CdS, CdSe, and CdTe, group IV semiconductors and compounds including but not limited to Si and Ge, organic semiconductors, metal oxides including but not limited to tungsten oxide, titanium oxide, nickel oxide, zirconium oxide, indium tin oxide, and chromium oxide, metal fluorides including but not limited to magnesium fluoride and calcium fluoride, metals including but not limited to Zn, In, Mg, and Sn, yttrium aluminum garnet (YAG), phosphide compounds, arsenide compounds, antimonide compounds, nitride compounds, high index organic compounds, and mixtures or alloys thereof. Gluing with high index inorganic adhesives is described in more detail in Application Serial Numbers 09/660,317, filed September 12,2000, published as U.S. Patent 7,053,419 B1 on May 30, 2006, and 09/880,204, filed June 12, 2001, published as U.S. Patent 7,064,355 B2 on June 20, 2006.

Gluing with sol-gel glasses is described in more detail in U.S. Patent 6,642,6 18. In embodiments where the luminescent ceramic is attached to the device by a sol-gel glass, one or more materials such as oxides of titanium, cerium, lead, gallium, bismuth, cadmium, zinc, barium, or aluminum may be included in the $SiO_2$ sol-gel glass to increase the index of refraction of the glass in order to more closely match the index of the glass with the indices of the luminescent ceramic and the light emitting device. For example, a $Y_3Al_5O_{12}$:$Ce^{3+}$ ceramic layer may have an index of refraction of between about 1.75 and 1.8, and may be attached to a sapphire growth substrate of a semiconductor light emitting device, which sapphire substrate has an index of refraction of about 1.8. It is desirable to match the refractive index of the adhesive to the refractive indices of the $Y_3Al_5O_{12}$:$Ce^{3+}$ ceramic layer and the sapphire growth substrate.

In some embodiments, a luminescent ceramic serves as a growth substrate for the semiconductor light emitting device. This is especially plausible with III-nitride light emitting layers such as InGaN, which are able to be grown on a lattice-mismatched substrate (e.g., sapphire or SiC), resulting in high dislocation densities, but still exhibit high external quantum efficiency in LEDs. Thus, a semiconductor light emitting device may be grown on a luminescent ceramic in a similar manner. For example, using metal-organic chemical vapor-phase epitaxy or another epitaxial technique, a III-nitride nucleation layer is deposited, typically at low temperature (~550°C), directly on the luminescent ceramic substrate. Then, a thicker layer of GaN ('buffer' layer) is deposited, typically at higher temperature, on the III-nitride nucleation layer and coalesced into a single crystal film. Increasing the thickness of the buffer layer can reduce the total dislocation density and improve the layer quality. Finally, n-type and p-type layers are deposited, between which light emitting III-nitride active layers are included. The ability to withstand the III-nitride growth environment (e.g., temperatures greater than 1,000 °C and an $NH_3$ environment) will govern the choice of luminescent ceramic as a growth substrate. Because the ceramics are poly-crystalline, and the resulting III-nitride layers should be single crystal, special additional growth considerations may apply. For example, for the situation described above, it may be necessary to insert multiple low-temperature interlayers within the GaN buffer layer to 'reset' the GaN growth and avoid ceramic grain orientation effects from propagating into the III-nitride device layers. These and other techniques are known in the art for growing on lattice-mismatched substrates. Suitable growth techniques are described in, for example, U.S. Patent 6,630,692 to Goetz et al., which is assigned to the assignee of the present application.

Though the examples below refer to III-nitride light emitting diodes, it is to be understood that embodiments of the invention may extend to other light emitting devices, including devices of other materials systems such as III-phosphide and III-arsenide, and other structures such as resonant cavity LEDs, laser diodes, and vertical cavity surface emitting lasers.

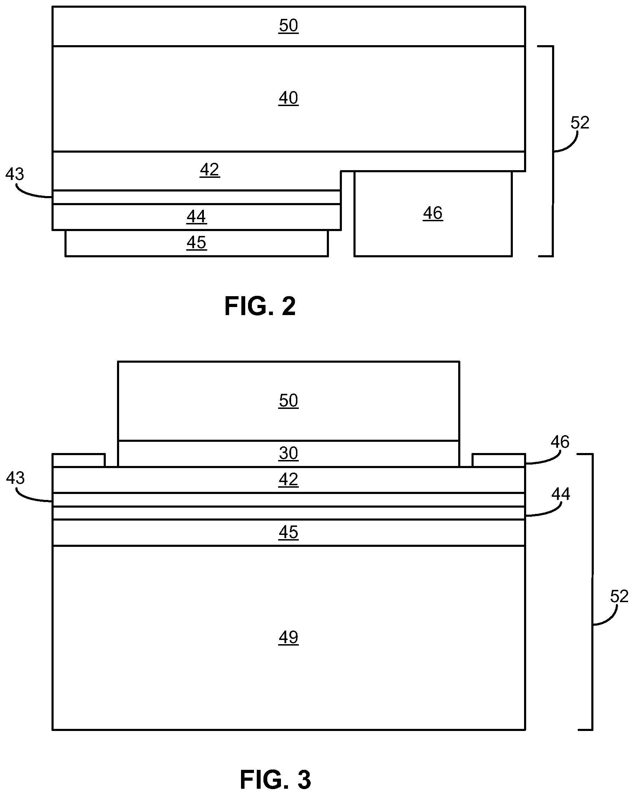

Figs. 2 and 3 illustrate III-nitride devices including luminescent ceramic layers. In the device of Fig. 2, an n-type region 42 is grown over a suitable growth substrate 40, followed by active region 43 and p-type region 44. Growth substrate 40 may be, for example, sapphire, SiC, GaN, or any other suitable growth substrate. Each of n-type region 42, active region 43, and p-type region 44 may include multiple layers of different composition, thickness, and dopant concentration. For example, n-type region 42 and p-type region 44 may include contact layers optimized for ohmic contact and cladding layers optimized to contain carriers within active region 43. Active region 43 may include a single light emitting layer, or may include multiple quantum well light emitting layers separated by barrier layers.

In the device illustrated in Fig. 2, a portion of p-type region 44 and active region 43 are etched away to reveal a portion of n-type region 42. A p-contact 45 is formed on the remaining portion of p-type region 44 and an n-contact 46 is formed on the exposed portion of n-contact 46. In the device illustrated in Fig. 2, contacts 45 and 46 are reflective such that light is extracted from the device through the back side of substrate 40. Alternatively, contacts 45 and 46 may be transparent or formed in such a way that a large portion of the surfaces of p-type region 44 and n-type region 42 are left uncovered by contacts. In such devices, light may be extracted from the device through the top surface of the epitaxial structure, the surface on which contacts 45 and 46 are formed.

In the device illustrated in Fig. 3, the epitaxial layers are bonded to a host substrate 49 through p-contact 45. Additional layers to facilitate bonding (not shown) may be included between p-type region 44 and host 49. After the epitaxial layers are bonded to host 49, the growth substrate may be removed to expose a surface of n-type region 42. Contact to the p-side of the active region is provided through host 49. An n-contact 46 is formed on a portion of the exposed surface of n-type region 42. Light is extracted from the device through the top surface of n-type region 42.

Growth substrate removal is described in more detail in Application Serial No. 10/804,810, filed March 19, 2004, titled "Photonic Crystal Light Emitting Device," assigned to the assignee of the present invention, and published as US 2005/0205883 A1 on September 22, 2005.

In the devices illustrated in Figs. 2 and 3, a luminescent ceramic layer 50 such as the ceramic layers described above, is attached to the surface of the device from which light is extracted; the back of substrate 40 in Fig. 2 and the top of n-type region 42 in Fig. 3. Ceramic layer 50 may be formed on or attached to any surface from which light is extracted from the device. For example, ceramic layer 50 may extend over the sides of the device illustrated in Fig. 2. Fig. 3 illustrates an optional filter 30, which allows light from active region 43 to pass into ceramic layer 50, but reflects light emitted by ceramic layer 50, such that light emitted by ceramic layer 50 is inhibited from entering device 52, where it is likely to be absorbed and lost. Examples of suitable filters include dichroic filters available from Unaxis Balzers Ltd. of Liechtenstein or Optical Coating Laboratory, Inc. of Santa Rosa, California.

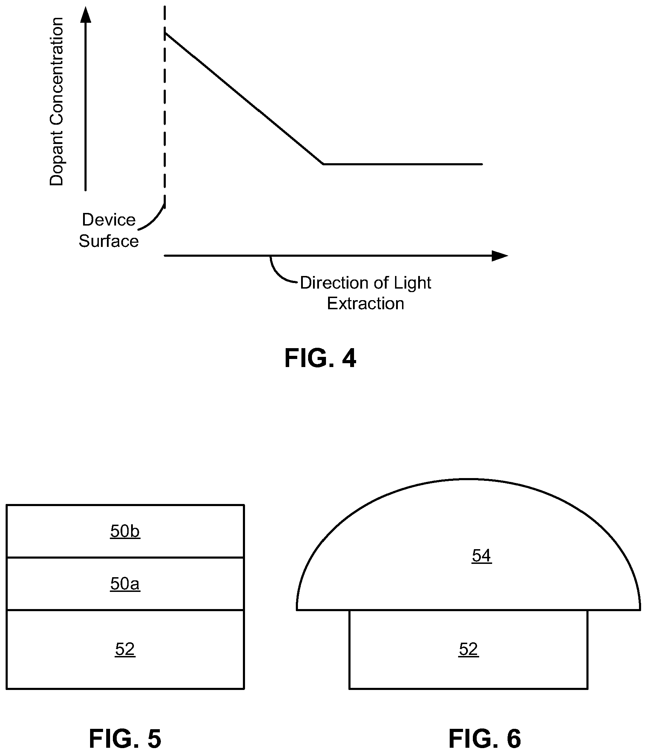

Luminescent ceramic layer 50 may include a single phosphor or multiple phosphors mixed together. In the context of the present invention, the amount of activating dopant in the ceramic layer may be graded. Fig. 4 illustrates an example of a graded doping profile in a luminescent ceramic layer. The dashed line in Fig. 4 represents the surface of the device. The phosphor in the portion of the ceramic layer closest to the device surface has the highest dopant concentration. As the distance from the device surface increases, the dopant concentration in the phosphor decreases. Though a linear dopant profile with a region of constant dopant concentration is shown in Fig. 4, it is to be understood that the grading profile may take any shape including, for example, a step-graded profile or a power law profile, and may include multiple or no regions of constant dopant concentration. In addition, it may be advantageous to reverse the grading profile, such that the region closest to the device surface has a small dopant concentration that increases as the distance from the device surface increases. Still in context of the present invention, the portion of the ceramic layer furthest from the device surface may not contain any phosphor or any dopant, and may be shaped (as shown below) for light extraction.

In the context of the present invention, the devices may include multiple ceramic layers, as in the device illustrated in Fig. 5. Ceramic layer 50a is attached to device 52, which may be, for example, either of the devices illustrated in Figs. 2 and 3. Ceramic layer 50b is attached to ceramic layer 50a. One of the two ceramic layers 50a and 50b may contain all the wavelength converting materials used in the device, and the other of the two ceramic layers may be transparent and used as a spacer layer, if it is the ceramic layer adjacent to device 52, or as a light extraction layer, if it is the ceramic layer furthest from device 52. Each of ceramic layers 50a and 50b may contain a different phosphor or phosphors. Though two ceramic layers are illustrated in Fig. 5, it is to be understood that devices including more than two ceramic layers and/or more than two phosphors are within the context of the present invention. The arrangement of the different phosphors in ceramic layers 50a and 50b or ceramic layers 50a and 50b themselves may chosen to control the interaction between the multiple phosphors in a device, as described in Application Serial No. 10/785,616 filed February 23, 2004 and published as US 2005/0184638 A1 on August 25, 2005. Though ceramic layers 50a and 50b are shown stacked over device 52 in Fig. 5, other arrangements are possible and within the context of the present invention. A device including one or more ceramic layers may be combined with other wavelength converting layers, such as the wavelength converting material shown in Fig. 1, or the thin films, conformal layers, and luminescent substrates described in the background section. Transparent ceramic layers that are not luminescent may be, for example, the same host material as the luminescent ceramic layer, without the activating dopant.

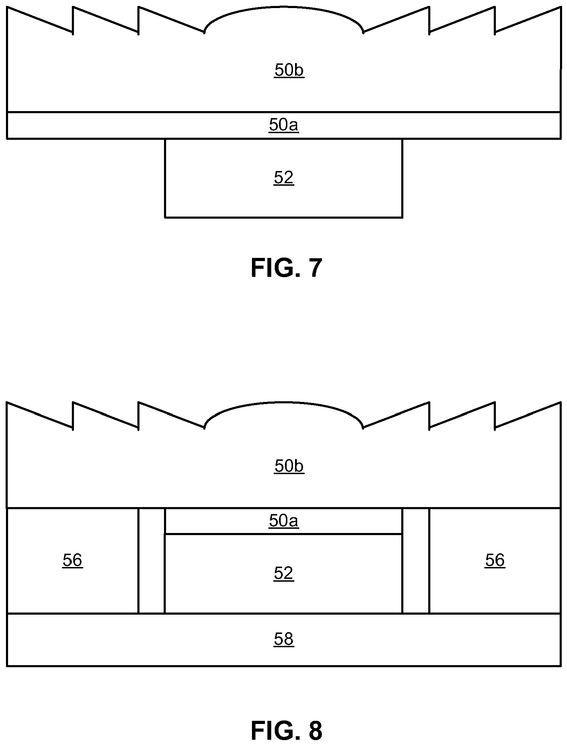

An advantage of luminescent ceramic layers is the ability to mold, grind, machine, hot stamp or polish the ceramic layers into shapes that are desirable, for example, for increased light extraction. Luminescent ceramic layers generally have high refractive indices, for example 1.75 to 1.8 for a $Y_3Al_5O_{12}$:$Ce^{3+}$ ceramic layer. In order to avoid total internal reflection at the interface between the high index ceramic layer and low index air, the ceramic layer may be shaped as illustrated in Figs. 6 and 7. In the device illustrated in Fig. 6, the luminescent ceramic layer 54 is shaped into a lens such as a dome lens. Light extraction from the device may be further improved by texturing the top of the ceramic layer, either randomly or in, for example, a Fresnel lens shape, as illustrated in Fig. 7. In the context of the present invention, the top of the ceramic layer may be textured with a photonic crystal structure, such as a periodic lattice of holes formed in the ceramic. The shaped ceramic layer may be smaller than or the same size as face of device 52 to which it is attached or it may be larger than the face of device 52 to which it is attached, as illustrated in Figs. 6 and 7. In devices such as Fig. 7, favorable light extraction is expected for shaped ceramic layers having a bottom length at least twice the length of the face of device 52 on which the ceramic layer is mounted. In the context of the present invention, the wavelength converting material may be confined to the portion of the ceramic layer closest to the device 52. Still in the context of the present invention, alternatively, as illustrated in Fig. 7, the wavelength converting material may be provided in a first ceramic layer 50a, then attached to a second, shaped, transparent ceramic layer 50b.

In the context of the present invention, the surface of the top ceramic layer may be roughened to increase scattering necessary to mix the light, for example, in a device where light from the light emitting device and one or more wavelength converting layers mixes to form white light. Alternatively, still in the context of the present invention, sufficient mixing may be accomplished by secondary optics such as a lens or light guide, as is known in the art.

A further advantage of luminescent ceramic layers is the favorable thermal properties of ceramics. A device including a luminescent ceramic layer and a heat extraction structure is illustrated in Fig. 8. As in Fig. 7, Fig. 8 includes a transparent or luminescent ceramic layer 50b that is shaped for light extraction. An optional additional transparent or luminescent ceramic layer 50a is disposed between layer 50b and device 52. Device 52 is mounted on a submount 58, for example as a flip chip as illustrated in Fig. 2. Submount 58 and host substrate 49 of Fig. 3, may be, for example, metals such as Cu foil, Mo, Cu/Mo, and Cu/W; semiconductors with metal contacts, such as Si with ohmic contacts and GaAs with ohmic contacts including, for example, one or more of Pd, Ge, Ti, Au, Ni, Ag; and ceramics such as compressed diamond. Layers 56 are thermally conductive materials that connect ceramic layer 50b to submount 58, potentially reducing the temperature of luminescent ceramic layer 50a and/or 50b, and thereby increasing light output. Material suitable for layers 56 include the submount material described above. The arrangement illustrated in Fig. 8 is particularly useful to extract heat from flip chip devices with conductive substrates, such as SiC.

EXAMPLE

An example of a cerium-doped yttrium aluminum garnet ceramic slab diffusion-bonded to a sapphire substrate is given below.

Diffusion-bonded YAG-sapphire composites are advantageous because of their high mechanical strength and excellent optical quality. According to the phase diagram yttria-alumina within the composition range $Al_2O_3$ and 3 $Y_2O_3$ 5 $Al_2O_3$, no other phase exists except an eutecticum with 33% Al. Therefore, a sinterbonded YAG-sapphire composite has an average refractive index at the (eutectoidic) interface between YAG ceramic ($n_i$ = 1.84) and sapphire substrate ($n_i$ = 1.76) and thus a high quality optical contact can be obtained. In addition, because of the similar expansion coefficients of YAG and sapphire (YAG: 6.9 x $10^{-6}$ $K^{-1}$, $Al_2O_3$: 8.6 x $10^{-6}$ $K^{-1}$), sinterbonded wafers with low mechanical stress can be produced.

A diffusion-bonded YAG:Ce ceramic-sapphire wafer may be formed as follows:

a) Production of YAG:Ce ceramic: 40 g $Y_2O_3$ (99.998%), 32 g $Al_2O_3$ (99.999%), and 3.44 g $CeO_2$ are milled with 1.5 kg high purity alumina balls (2 mm diameter) in isopropanol on a roller bench for 12 hrs. The dried precursor powder is then calcined at 1300°C for two hours under CO atmosphere. The YAG powder obtained is then deagglomerated with a planet ball mill (agate balls) under ethanol. The ceramic slurry is then slip casted to obtain a ceramic green body after drying. The green bodies are then sintered between graphite plates at 1700°C for two hours.

b) Diffusion-bonding of a sapphire waver and a YAG:Ce ceramic: The ground and polished sapphire and YAG wafers are diffusion bonded in a uniaxial hot pressing apparatus (HUP). For this purpose sapphire and YAG wafers are stacked between tungsten foils (0.5 mm thickness) and placed in a graphite pressing die. To increase the speed of processing several sapphire / YAG:Ce ceramic / tungsten foil stacks can be stacked and processed simultaneously. After evacuation of the HUP apparatus the temperature is first increased to 1700°C within 4 hrs without applying external pressure. Then a uniaxial pressure of 300 bar is applied and kept constant for 2 hrs. After the dwell time the temperature is lowered to 1300°C within 2 hrs by keeping the pressure constant. Finally the system is cooled down to room temperature within 6 hrs after releasing the pressure.

c) Post processing of sinterbonded sapphire-YAG:Ce wafers: After grinding and polishing of the surfaces of the sinterbonded wafers, the samples are annealed for 2 hrs at 1300°C in air (heating rate: 300 K/hr), then cooled down to room temperature within 12 hrs.

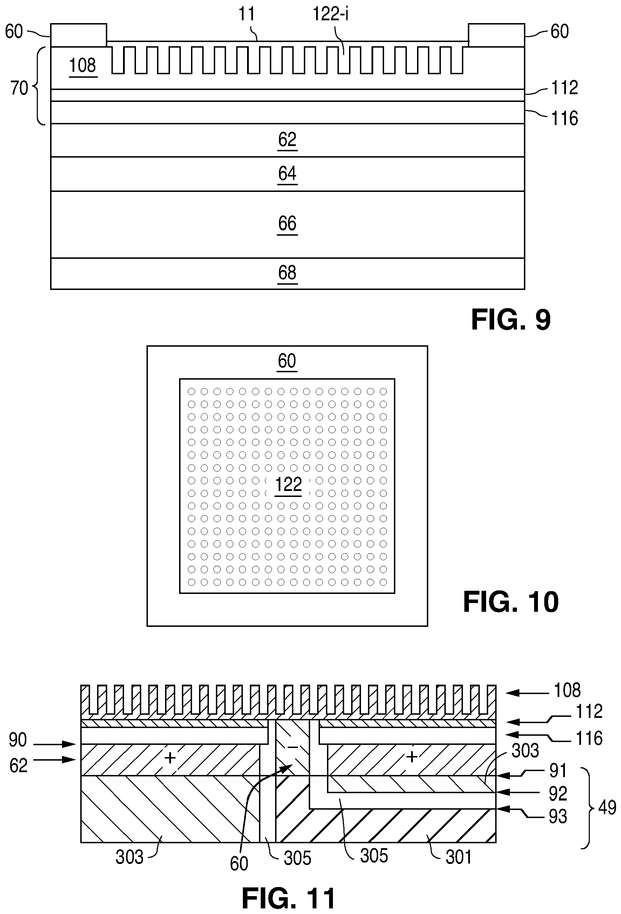

In the context of the present invention, a photonic crystal may be formed in an n-type layer of a III-nitride device attached to a host substrate and from which the growth substrate has been removed. Such devices may emit light between about 280 and about 650 nm and usually emit light between about 420 and about 550 nm. Fig. 9 is a cross sectional view of an example, not defining in itself, i.e. in isolation, the present invention, comprising a photonic crystal. Fig. 10 is a plan view of the device of Fig. 9. As illustrated in Fig. 9, the photonic crystal 122 is formed in n-type region 108, rather than p-type region 116. N-contact 60 is formed on a region of n-type region 108 that is not textured with the photonic crystal, though in other examples n-contact 60 may be formed on the photonic crystal area of n-type region 108. Since the photonic crystal is formed in an n-type region, the n-type material is able to laterally inject current from contact 60 to photonic crystal 122. Light is extracted from the device through photonic crystal 122, thus the arrangement of n-contact 60 is selected to maximize the area of the photonic crystal. For example, as illustrated in Fig. 10, n-contact 60 may surround photonic crystal region 122-i. N-contact 10 is not limited to a ring contact but could also be a grid or other structure that facilitates proper current spreading. To avoid light being absorbed by the n-contact 60, implantation or a dielectric can be used on the epitaxial material under n-contact 60, preventing current flow and light generation in that area. A reflective p-contact 62 is formed on p-type region 116. The device of Fig. 9 has the p- and n-contacts formed on opposite sides of the device. P-contact 62 connects the epitaxial layers 70 to a host substrate 66 either directly or via optional bonding layers 64. An optional contact 68 may be formed on the surface of host substrate 66 opposite the device layers 70.

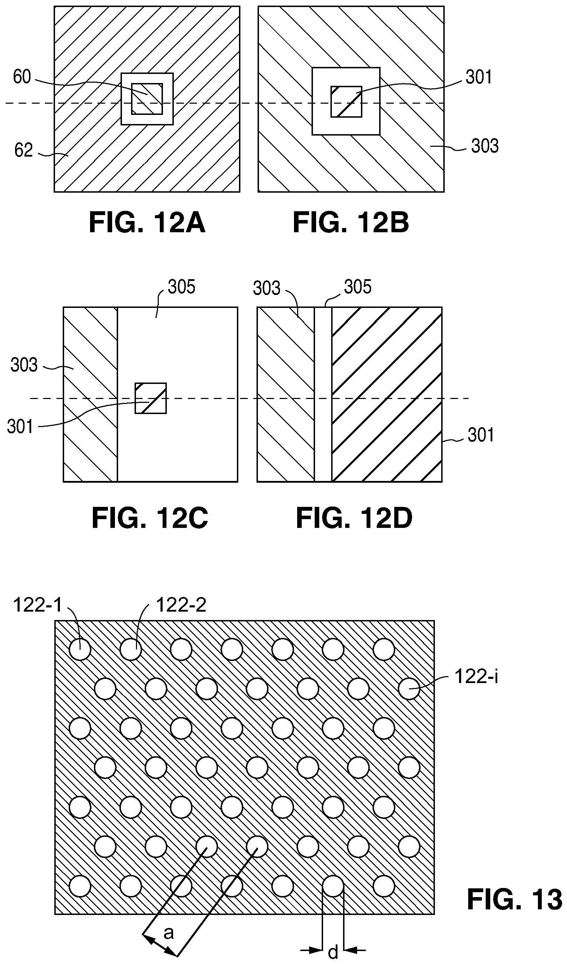

Figs. 11 and 12A-12D illustrate an alternative example, not defining in itself, i.e. in isolation, the present invention, comprising a photonic crystal. Figs. 12A, 12B, 12C, and 12D are cut away plan views along axes 90, 91, 92, and 93, respectively, illustrated in the cross sectional view of Fig. 11. In the device of Fig. 11, both p and n-contacts 62 and 60 are on the host substrate side of the device, eliminating absorption of light by a top side n-contact, as in the device of Figs. 9 and 10. One or more vias are etched down to n-type region 108 through p-type region 116 and active region 112 to make n-contact 60. Host substrate structure 49 is fabricated in a layered structure to electrically isolate the p- and n-contacts. An example of the layer structure is illustrated by Figs. 12A-12D, which show plan view slices of the host substrate along axes 90, 91, 92, and 93 of Fig. 13. N-metal 301 and p-metal 303 are routed such that at the bottom of the host substrate the positive and negative contacts are separate and can be easily soldered to another structure. N-metal 301 and p-metal 303 may be electrically isolated by dielectric 305. Depending on the area of the LED one or more n-contact vias may be necessary to provide sufficient current spreading. Bonding the patterned LED to the patterned host can be accomplished using a flip-chip bonder.

Bonding the epitaxial layers of the device to a host substrate, then removing the growth substrate allows the photonic crystal structure of the device to be formed in an n-type region. Etching the photonic crystal structure in an n-type region rather than a p-type region avoids type-conversion associated with etching p-type Also, vacancies introduced in the n-type region from etching do not affect the conductivity of the material. In addition, since the photonic structure in n-type region 108 is separated from p-type region 116 and active region 112, damage to these regions caused by etching the photonic structure is avoided. The exposed top n-type layer allows for formation of the photonic crystal proximal to the active region. In the context of the present invention, when surface recombination is low, the photonic crystal may penetrate the active region and p-type region.

Alternatively, rather than bonding the epitaxial layers to a host, then removing the growth substrate, a device with an exposed top n-type region may be formed by growing the p-type region first on a growth substrate, followed by an active region and n-type region. Ignoring the growth difficulties, this would present n-type layer on the surface just as in Fig 9, such that etching damage is not a concern. Contacts to the p-GaN layers would have to be formed on the surface by first exposing the p-type layers by etching a mesa. Therefore current would have to spread laterally along resistive p-type layers, creating a device with high operating voltage, a result that is undesirable in many applications. Altenatively, the substrate could be removed from this structure so that the operating voltage is not high. This is done by first bonding a host to the top n-type layers and then removing the growth substrate. Next etching is performed to remove the initial growth layers and expose the p-type region. Then a second bonding step with a second host is performed on the now-exposed p-type layers. The first host is removed re-exposing the n-type region for photonic crystal formation. The resulting structure is the same as Fig 9.

The photonic crystal structure can include a periodic variation of the thickness of n-type region 108, with alternating maxima and minima. An example is a grating (one-dimensional lattice) or planar lattice of holes 122 (two-dimensional lattice). The lattice is characterized by the diameter of the holes, d, the lattice constant a, which measures the distance between the centers of nearest neighbor holes, the depth of the holes w, and the dielectric constant of the dielectric, disposed in the holes, $\varepsilon_h$. Parameters a, d, w, and $\varepsilon_h$ influence the density of states of the bands, and in particular, the density of states at the band edges of the photonic crystal's spectrum. Parameters a, d, w, and $\varepsilon_h$ thus influence the radiation pattern emitted by the device, and can be selected to enhance the extraction efficiency from the device. Alternatively, when the proper photonic crystal parameters are chosen, the radiation pattern of the emitted light can be narrowed, increasing the radiance of the LED. This is useful in applications where light at only specific angles is useful. In the context of the present invention, the photonic crystal parameters may be chosen such that greater than 50% of radiation exiting the device is emitted in an exit cone defined by an angle of 45 degrees to an axis normal to a surface of the device.

Holes 122-i can be arranged to form triangular, square, hexagonal, honeycomb, or other well-known two-dimensional lattice types. In the context of the present invention, different lattice types may be formed in different regions of the device. Holes 122-i can have circular, square, hexagonal, or other cross sections. Still in the context of the present invention the lattice spacing a may be between about 0.1 $\lambda$ and about 10 $\lambda$, preferably between about 0.1 $\lambda$ and about 4 $\lambda$, where $\lambda$ is the wavelength in the device of light emitted by the active region. Holes 122 may have a diameter d between about 0.1 a and about 0.5 a, where a is the lattice constant. Holes 122-i can be filled with air or with an optional dielectric 11 (Fig. 9) of dielectric constant $\varepsilon_h$, often between about 1 and about 16. Possible dielectrics include silicon oxides.

Photonic crystal 122 and the reflection of the photonic crystal from reflective p-contact 62 form a GaN resonant cavity. The resonant cavity offers superior control of the light. As the GaN cavity is thinned the optical mode volume is reduced. Fewer waveguided modes can be trapped in the cavity increasing the chances for the light to exit the device. This can be explained in the following discussion. The photonic crystal can affect the waveguided modes by scattering them out of the crystal. As the number of waveguided modes is reduced the more efficient the light extraction of the LED. For example if the epitaxial layers are thin enough to support only one waveguided mode (m), then initially 50% of the light would exit the GaN ($L_{out}$) and 50% would be waveguided in the epitaxial layers ($L_{in}$). For this argument we assume that we form a photonic crystal that is able to extract an additional 40% of this waveguided light ($S_{eff}$). The extraction efficiency ($C_{ext}$) can be written as:

$$C_{ext} = L_{out} + m * (L_{in} \text{ x } S_{eff})$$

Therefore the extraction efficiency of this structure is 50% + 1* (50% * 40%) = 70%. Compare this to an epitaxial structure that supports 4 waveguided modes with a photonic crystal again with $S_{eff}$=40%. If the light goes equally into all modes then each mode including the one exit mode has 20% of the light. This structure would only have an extraction efficiency of 20% + 4 * (20% * 40%) =52 %. In this argument the photonic crystal is not 100% efficient scattering out the light. In the context of the present invention, the photonic crystal may be etched deep enough to have the proper lattice dimensions so that a photonic band gap is created in the plane of the LED inhibiting waveguide modes ($S_{eff}$=100%). The thinner the epitaxial layers the easier it is to create a photonic bandgap. The thickness of the cavity (i.e. the thickness of epitaxial layers 70) is selected such that the epitaxial layers are as thin as possible to reduce the number of waveguided modes, but thick enough to efficiently spread current. In many embodiments, the thickness of epitaxial layers 70 is less than about 1 $\mu$m, and preferably less than about 0.5 $\mu$m.

In the context of the present invention, the thickness of epitaxial layers 70 may be between about $\lambda$ and about 5$\lambda$, between about 0.18 $\mu$m and about 0.94 $\mu$m for a device that emits 450 nm light. Holes 122 may have a depth between about 0.05 $\lambda$ and the entire thickness of n-type region 108. Generally, holes 122 are formed entirely within n-type region 108 and do not penetrate into the active region. N-type region 108 usually has a thickness of about 0.1 microns or more. The depth of holes 122 is selected to place the bottoms of holes 122 as close to the active region as possible without penetrating the active region. Alternatively, still in the context of the present invention, the photonic crystal may penetrate the active layers and p-type layers.

The radiation pattern emitted from the device can be tuned by changing the lattice type, distance between the active region and the photonic crystal, lattice parameter a, diameter d, depth w, and epitaxial thickness (70). The lattice parameter a and diameter d are illustrated in Fig. 13. In the context of the present invention, the radiation pattern from the device may be adjusted to emit light preferentially in a chosen direction.

In the context of the present invention, the periodic structure is a variation of the thickness of one or more selected semiconductor layers. The periodic structure can include variations of the thickness along one direction within the plane of the semiconductor layers, but extending along a second direction without variation, in essence forming a set of parallel grooves. Two-dimensional periodic variations of the thickness include various lattices of indentations.

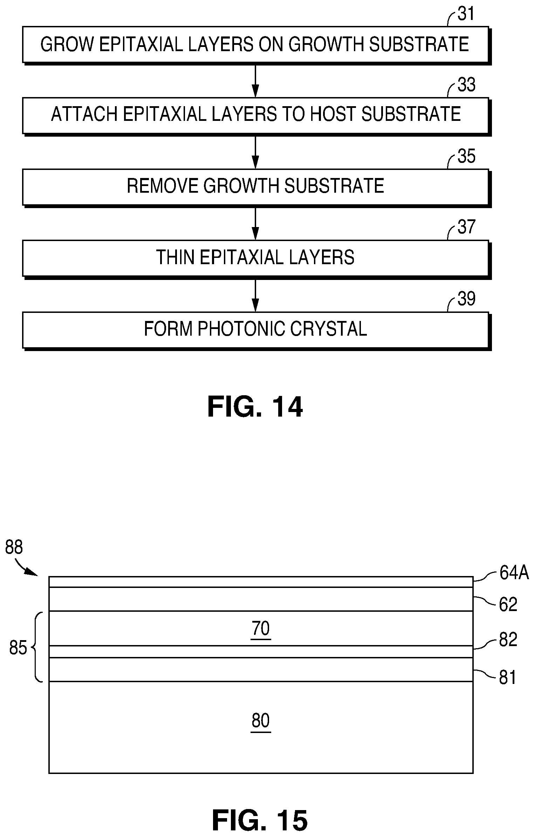

The device illustrated in Figs. 9 and 10 may be fabricated by the method illustrated in Fig. 14. In stage 31, epitaxial layers 70 of Fig. 9 are grown on a conventional growth substrate. The epitaxial layers are then attached to a host substrate in stage 33, such that the growth substrate can be removed in stage 35. The epitaxial layers may be thinned in optional stage 37, then a photonic crystal structure is formed on the exposed surface of the epitaxial layers in stage 39.

Fig. 15 illustrates stage 31 of Fig. 14 in more detail. Epitaxial layers 70 of the device of Fig. 2 are grown on a substrate 80 such as sapphire, SiC, or GaN. Optional preparation layers 81, which may include, for example, buffer layers or nucleation layers, may be grown first on substrate 80 to provide a suitable growth substrate. One or more optional etch stop layers 82 may then be grown. Etch stop layers 82 may facilitate release of the growth substrate or facilitate thinning of the epitaxial layers, as described below. The epitaxial layers 70 are grown over etch stop layers 82 and include n-type region 108, active region 112, and p-type region 116. Usually, the n-type region is grown first, followed by the active region and the p-type region. A p-contact 62, often reflective, is formed on the surface of p-type region 116. P-contact 62 may be a single layer or may include multiple layers such as an ohmic contact layer, a reflective layer, and a guard metal layer. The reflective layer is usually silver or aluminum. The guard metal may include, for example, nickel, titanium, or tungsten. The guard metal may be chosen to prevent the reflective metal layer from migrating, particularly in the case of a silver reflective layer, and to provide an adhesion layer for a bonding layer 64A, used to bond the epitaxial structure to a host substrate.

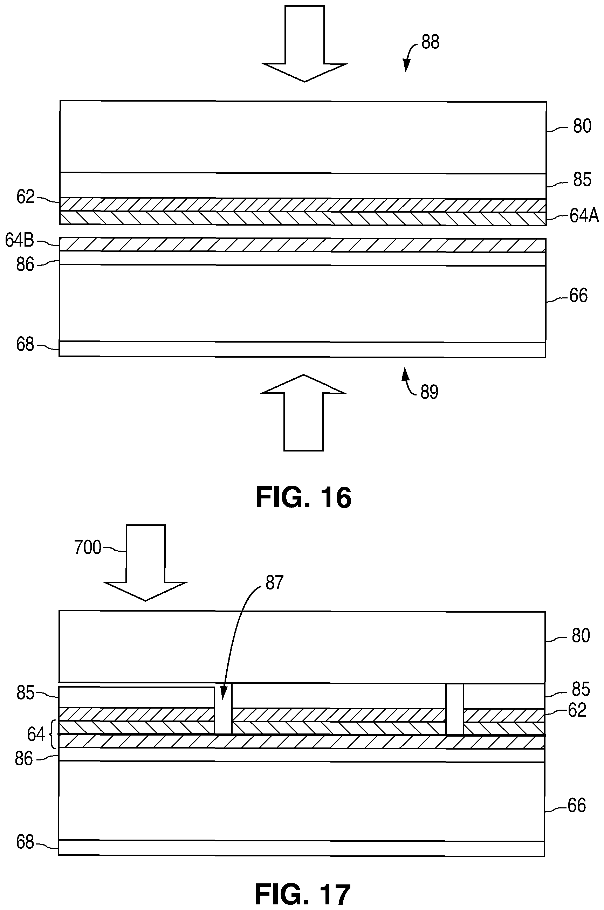

Fig. 16 illustrates stage 33 of Fig. 14, attaching the epitaxial layers to a host substrate, in more detail. Bonding layers 64A and 64B, typically metal, serve as compliant materials for thermo-compression or eutectic bonding between the epitaxial structure and the host substrate. Examples of suitable bonding layer metals include gold and silver. Host substrate 66 provides mechanical support to the epitaxial layers after the growth substrate is removed, and provides electrical contact to p-contact 62. Host substrate 66 is selected to be electrically conductive (i.e. less than about 0.1 $\Omega$cm), to be thermally conductive, to have a coefficient of thermal expansion (CTE) matched to that of the epitaxial layers, and to be flat (i.e. with an root mean square roughness less than about 10 nm) enough to form a strong wafer bond. Suitable materials include, for example, metals such as Cu, Mo, Cu/Mo, and Cu/W; semiconductors with metal contacts (layers 86 and 68 of Fig. 16), such as Si with ohmic contacts and GaAs with ohmic contacts including, for example, one or more of Pd, Ge, Ti, Au, Ni, Ag; and ceramics such as compressed diamond. The table below lists the properties of some suitable host substrates, as well as the properties of GaN and $Al_2O_3$ for comparison:

| Material | CTE ($10^{-6}$/K) | Thermal conductivity (W/m·K) | Electrical resistance ($\Omega$cm) |
|---|---|---|---|
| GaN | 2.4 | 130 | 0.01 |
| $Al_2O_3$ | 6.8 | 40 | Very high |
| Si | 2.7 | 150 | 0.01 plus contact resistance |
| GaAs | 6.0 | 59 | 0.01 plus contact resistance |
| Mo | 4.8 | 140 | $5x10^{-6}$ |

Host substrate structure 89 and epitaxial structure 88 are pressed together at elevated temperature and pressure to form a durable metal bond between bonding layers 64A and 64B. In the context of the present invention, bonding may be done on a wafer scale, before a wafer with an epitaxial structure is diced into individual devices. The temperature and pressure ranges for bonding are limited on the lower end by the strength of the resulting bond, and on the higher end by the stability of the host substrate structure and the epitaxial structure. For example, high temperatures and/or high pressures can cause decomposition of the epitaxial layers in structure 88, delamination of p-contact 62, failure of diffusion barriers, for example in p-contact 62, or outgassing of the component materials in the epitaxial layers. A suitable temperature range is, for example, about 200°C to about 500°C. A suitable pressure range is, for example, about 100 psi to about 300 psi.

Fig. 17 illustrates a method of removing a sapphire growth substrate, stage 35 in Fig. 14. Portions of the interface between sapphire substrate 80 and the III-nitride layers 85 are exposed, through the sapphire substrate, to a high fluence pulsed ultraviolet laser 700 in a step and repeat pattern. The photon energy of the laser is above the band gap of the III-nitride layer adjacent to the sapphire (GaN in the context of the present invention), thus the pulse energy is effectively converted to thermal energy within the first 100 nm of epitaxial material adjacent to the sapphire. At sufficiently high fluence (i.e. greater than about 1.5 J/cm$^2$) and a photon energy above the band gap of GaN and below the absorption edge of sapphire (i.e. between about 3.44 and about 6 eV), the temperature within the first 100 nm rises on a nanosecond scale to a temperature greater than 1000 °C, high enough for the GaN to dissociate into gallium and nitrogen gasses, releasing the epitaxial layers 85 from substrate 80. The resulting structure includes epitaxial layers 85 bonded to host substrate structure 89.

Exposure to the laser pulse results in large temperature gradients and mechanical shock waves traveling outward from the exposed region, resulting in thermal and mechanical stress within the epitaxial material sufficient to cause cracking of the epitaxial material and failure of wafer bond 64, which limits the yield of the substrate removal process. The damage caused by thermal and mechanical stresses may be reduced by patterning the epitaxial structure down to the sapphire substrate or down to a suitable depth of the epitaxial structure, to form trenches between individual devices on the wafer. The trenches are formed by conventional masking and dry etching techniques, before the wafer is bonded to the host substrate structure. The laser exposure region is then matched to the pattern of trenches on the wafer. The trench isolates the impact of the laser pulse to the semiconductor region being exposed.

Growth substrates other than sapphire may be removed with ordinary chemical etchants, and thus may not require the laser exposure substrate removal procedure described above. For example, a suitable growth substrate may include a thin layer of SiC grown or processed on to a thick layer of Si or $SiO_x$. The Si base layer and/or oxide layer may be easily removed by conventional silicon processing techniques. The remaining SiC layer may be thin enough to be removed entirely by known etching techniques. N-contact 60 may then be formed on the exposed surface of the epitaxial layers. Alternatively, N-contact 60 may be formed in the holes in the SiC layer.

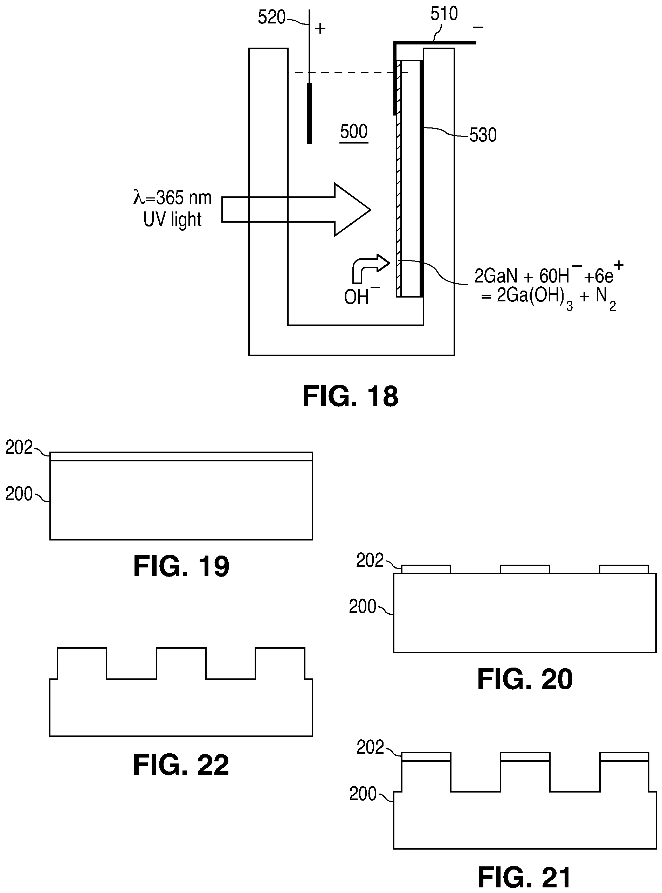

After the growth substrate is removed, the remaining epitaxial layers may optionally be thinned to form a cavity between the photonic crystal and p-contact 62 of optimal depth and of uniform thickness, usually with thickness variations less than about 20 nm. The epitaxial layers may be thinned by, for example, chemical mechanical polishing, conventional dry etching, or photoelectrochemical etching (PEC). PEC is illustrated in Fig. 18.

As illustrated in Fig. 18, the host substrate and epitaxial layers (structure 530) are immersed in a basic solution 500. An example of a suitable basic solution is 0.1 M KOH, though many other suitable basic solutions may be used and typically depend on the composition of the material to be etched. The epitaxial surface of structure 530, often an n-type GaN layer, is exposed to light with energy greater than the band gap of the surface layer. In the example illustrated in Fig. 18, ultraviolet light with a wavelength of about 365 nm and an intensity between about 10 and about 100 mW/cm$^2$

is used. Exposure to the light generates electron-hole pairs in the surface semiconductor layer. The holes migrate to the surface of the epitaxial layers under the influence of the electric field in the n-type semiconductor. The holes then react with the GaN at the surface and basic solution 500 to break the GaN bonds, according to the equation $2GaN + 6OH^- + 6e^+ = 2Ga(OH)_3 + N_2$. An external electric potential may be applied across electrodes 510 and 520 to accelerate and control the etching process.

In the context of the present invention, an etch stop layer may be incorporated into the epitaxial layers, as described above in Fig. 14. The etch stop layer may have a band gap greater than the layer to be etched. For example, the etched layer may be GaN, and the etch stop layer may be AlGaN. The light sources used to expose structure 530 is selected to have an energy greater than the band gap of the layer to be etched, but less than the band gap of the etch stop layer. Accordingly, exposure to the light does not generate electron-hole pairs in the etch stop layer, effectively halting the etch once the etch stop layer is reached. In the context of the present invention, InGaN may be used as the etch stop layer. Indium oxide, formed as the InGaN decomposes, is insoluble in the etchant solution and coats the surface of the etched layer, terminating the etch.

Though the example illustrated in Fig. 9 shows an n-type region with the same thickness in the photonic crystal region and in the region underlying contact 60, in other examples a three dimensional structure may be formed on n-type region 108 during thinning. For example, n-type region 108 may be patterned such that the portion under contact 60 is thicker than the portion forming the photonic crystal, in order to minimize the thickness of the cavity, while providing enough n-type material under contact 60 for adequate current spreading, optimal contact resistance, and mechanical strength.

After thinning, the photonic crystal structure is formed on the exposed surface of the epitaxial layers. Figs. 19-22 illustrate a method of fabricating the photonic crystal structure of the device of Fig. 9. One or more resist, metal, or dielectric layers 202 are formed over the top surface of the epitaxial layers 200, as illustrated in Fig. 19. Resist layers 202 are patterned to form a lattice of openings in Fig. 20, using a high resolution lithography technique such as electron beam lithography, nano-imprint lithography, deep X-ray lithography, interferometric lithography, hot embossing, or microcontact printing. In Fig. 21, epitaxial layers 200 are etched using known etching techniques. Damage caused by dry etching can be mitigated by a subsequent short wet chemical etch, anneal, a combination thereof, or other surface passivation techniques. The remaining resist layer 202 is then removed in Fig. 22. Other techniques may be used to form a photonic crystal, such as epitaxial lateral overgrowth. As illustrated in Fig. 9, a portion of the surface of the exposed n-type layer may not be textured with a photonic crystal, such that n-contact 60 may be formed on a planar layer. After the photonic crystal is formed, n-contact 60 is deposited by conventional techniques.

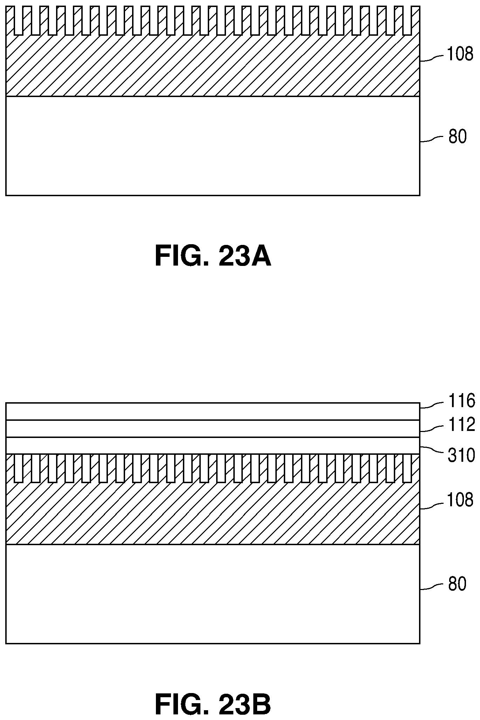

Figs. 23A and 23B illustrate an alternative method for forming the photonic crystal. Rather than etching the photonic crystal after removing the growth substrate, a buried photonic crystal is formed during epitaxial growth. In Fig. 23A, epitaxial growth is stopped before the active layers are grown. A photonic crystal is then formed in n-type region 108, for example, by etching as illustrated above in Figs. 19-22. The material is then placed back into the growth reactor and first a smoothing n-type layer 310, often GaN, is grown. The depth of the photonic crystal holes is greater than the diameter of the holes. The growth parameters of smoothing layer 310 are chosen so lateral growth is faster than vertical growth, ensuring that the photonic crystal holes are not filled. Once the smoothing layer 310 is closed over the photonic crystal holes in n-type region 108, active region 112 and p-type region 116 are grown. A contact may then be formed on p-type region 116, and the growth substrate removed as described above.

In the process illustrated in Fig. 17, a wafer of devices is connected to a wafer of mounts, then the substrate is removed and the wafer is diced into individual devices. Alternatively, a wafer of devices may be diced into individual devices before the substrate is removed. Each device is then flipped relative to the growth direction and mounted on a mount; then the substrate is removed from each individual device. In such cases, the mount may have a lateral extent larger than that of the device. The device may be mounted on the mount by interconnects such as solder or gold stud bumps. A rigid underfill may be provided between the device and the mount before or after mounting to support the semiconductor layers and prevent cracking during substrate removal. A photonic crystal may be formed in the exposed surface of the semiconductor, after removing the growth substrate. Prior to forming the photonic crystal, the semiconductor structure may be thinned, for example by dry or wet etching.

In the present invention, a luminescent ceramic layer is disposed in a path of light emitted by a light emitting semiconductor diode structure incorporating a variation in refractive index, defining a photonic crystal, formed on a surface of or within the semiconductor structure. As an alternative, not forming part of the present invention, since it does not introduce a periodicity or pseudo-periodicity, that is a photonic crystal, the variation in refractive index may be a random arrangement of features and the lateral extent of each feature is more or less than twice a peak emission wavelength of the light emitting layer. In the present invention, the variation in refractive index is a periodic arrangement of features with a period more than twice a peak emission wavelength of the light emitting layer, defining thus a photonic crystal. For example, a photonic crystal, as shown for example in Fig. 9, may be formed in n-type region 42 of Fig. 3. Luminescent ceramic 50 may be disposed, according to an illustrative example not forming part of the present invention, immediately adjacent the photonic crystal in region 42, or, in accordance with the present invention, may be separated from the photonic crystal by filter, i.e. light valve, structure 30.

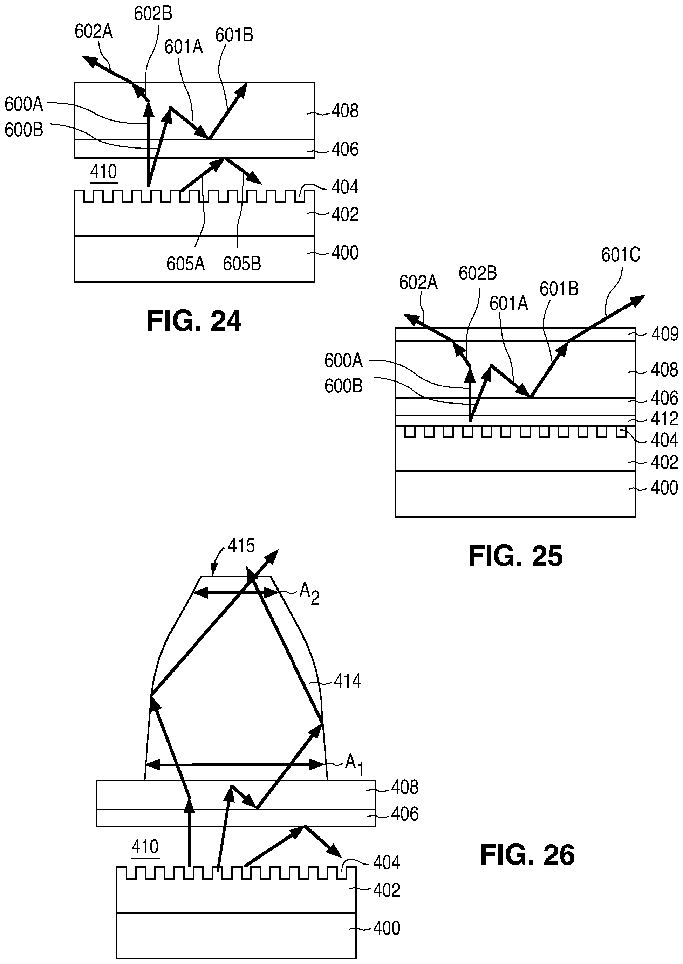

Figs. 24, 25, 26, 27, 28, and 29 illustrate devices in accordance with the present invention including semiconductor structures with a photonic crystal, a luminescent ceramic, and a light valve 406. Light valve 406 is often a dielectric stack, such as a distributed Bragg reflector (DBR) or a dichroic filter; a two-dimensional photonic crystal; or a three-dimensional photonic crystal. The light valve transmits photons emitted by the active region (photons 600A and 600B in Fig. 24) and reflects photons that have been converted by the luminescent ceramic (photons 601A and 601B), directing the converted photons away from the semiconductor structure and forcing them out of the device (photons 602A, 601B, and 602B). The light valve thus prevents absorption of the converted photons by the semiconductor structure, potentially increasing the conversion efficiency of the system.

Photons emitted by the active region of the semiconductor structure striking the interface of a light valve at angles near normal to the surface (0°) of the light valve are transmitted (photons 600A and 600B); photons striking the interface of the light valve at higher angles relative to the surface of the light valve are reflected (photons 605A and 605B). The reflection and transmission characteristics of the light valve thus depend on the incident angle of each photon striking the light valve. When disposed between the light emitting layers and the luminescent ceramic, a light valve may also reflect light converted by the luminescent ceramic and traveling toward the semiconductor structure.

As described above, a common light valve is a dielectric stack, which typically includes multiple layers of alternating materials with varying refractive index. One example of a suitable dielectric stack includes six pairs of $SiO_2$ and $TiO_2$. In one preferred embodiment, a suitable dielectric stack transmits greater than 90% of blue light emitted by the semiconductor structure and reflects greater than 90% of yellow light emitted by the luminescent ceramic, for as wide an angular range as possible.

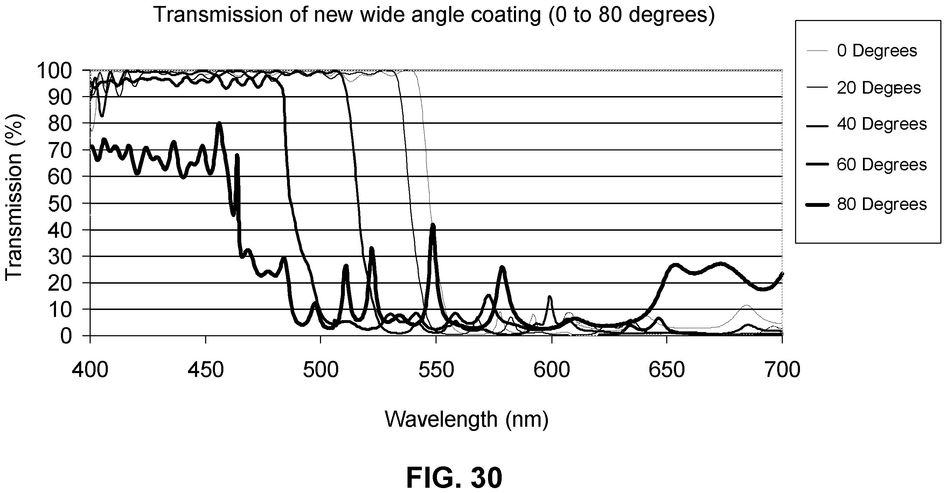

Fig. 30 illustrates the angular dependency of a state-of-the-art dielectric stack available from Bookham of San Jose, CA. The transmission of this dielectric stack is greater than 90% for incident angles less than 70°, for blue wavelengths. At higher incident angles the dielectric stack becomes less transmissive to blue wavelengths. The transmission of yellow wavelengths is low for incident angles less than 70°.

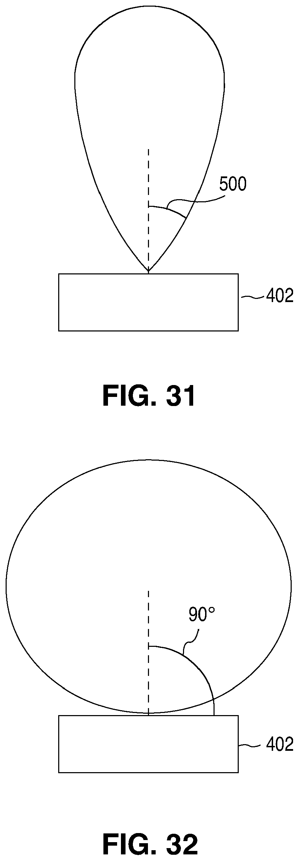

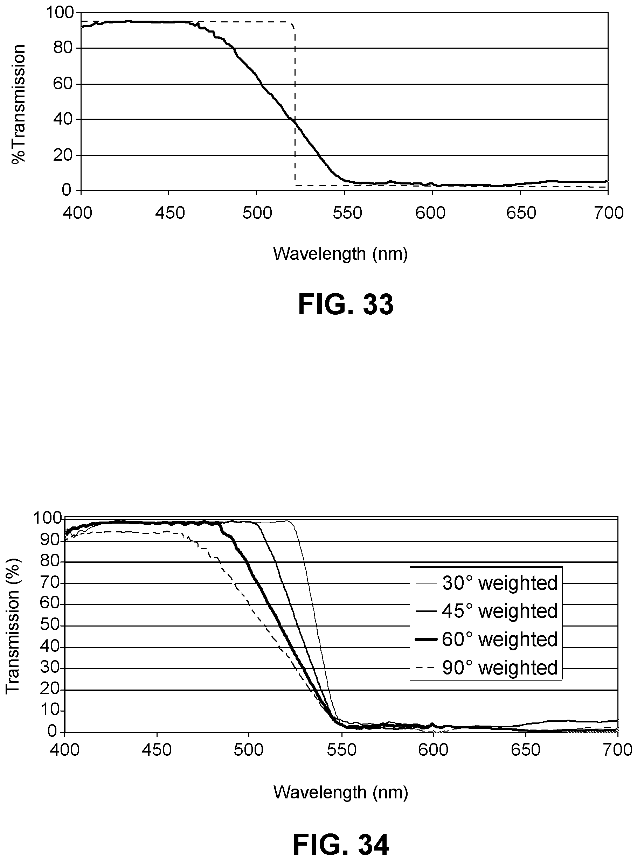

Fig. 33 illustrates percent transmission of the total light (i.e. the sum of light emitted at all angles) as a function of wavelength for two systems. The solid line in Fig. 33 illustrates the transmission through the light valve illustrated in Fig. 30, when combined with a semiconductor structure that emits light in a Lambertian pattern. An example of light emitted in a Lambertian pattern is shown in Fig. 32. LEDs where the surface from which light is extracted is rough may emit light in a Lambertian pattern. As illustrated in Fig. 33, the transmission is high in the blue (<460nm) and low in the yellow (>550nm) with a wide range of wavelengths where the transmission changes from high to low (460-550nm). For best performance, it is necessary to select semiconductor structures and luminescent ceramics that emit at wavelengths outside the range of transition wavelengths (460-550nm). The broader the range of transition wavelengths, the smaller the pool of possible semiconductor structures and luminescent ceramics. Since it is desirable that the semiconductor emitting wavelengths and the luminescent ceramic emitting wavelengths be close together, it is preferable to limit the transition wavelength range of the light valve.

The dotted line in Fig. 33 illustrates the transmission through the light valve illustrated in Fig. 30, when combined with a semiconductor structure that emits light in a narrow radiation pattern. An example of light emitted in a narrow radiation pattern is shown in Fig. 31. LEDs including a photonic crystal may emit light in a narrow radiation pattern. As illustrated by the dotted line in Fig. 33, with a device that emits a narrow radiation pattern, the transmission changes from high to low over a much narrower wavelength range than a device that emits light in a Lambertian pattern, shown by the solid line. The broad wavelength range over which the transmission changes for the Lambertian device may undesirably reduce the efficiency of the system. The narrow wavelength range of the transition for the narrow radiation pattern device allows the efficient use of a larger pool of semiconductor emitting wavelengths and luminescent ceramic emitting wavelengths. The semiconductor emitting wavelength that gives the best conversion efficiency in the luminescent ceramic may be chosen, which may increase the efficiency of the system and increase the possible range of emitting wavelengths.

The angular emission from a photonic crystal 404 formed within or on a surface of the semiconductor structure can be tailored for a particular light valve. For example, Fig. 34 illustrates the performance of a light valve consisting of a dielectric stack combined with four possible LED devices, devices where the light is emitted into narrow emission cones of +- 30°, +-45° and +-60°, and a device where light is emitted in a Lambertian pattern (corresponding to an emission cone of +-90°). As is clear from Fig. 34, the more narrow the emission cone, the smaller the range of wavelengths over which transmission changes from high to low. Reducing the range of wavelengths over which transmission changes from high to low may improve the efficiency of the device, particularly in devices including a wavelength converting material such as a luminescent ceramic.

In each of the devices according to the present invention illustrated in Figs 24-29, the semiconductor structure may be connected to the host substrate with the first contact on a top surface of the semiconductor structure and the second contact disposed between the host substrate and the semiconductor structure, as illustrated in Fig. 9, or with both contacts disposed between the semiconductor structure and the host substrate, as illustrated in Fig. 11.

In the device illustrated in Fig. 24, a semiconductor structure 402 including a photonic crystal 404 formed in the surface is connected to a host 400. A light valve 406 is connected to a luminescent ceramic 408, for example by depositing dielectric stack layers on the luminescent ceramic. The combination of light valve 406 and luminescent ceramic 408 is disposed in the path of light emitted from the light emitting layers of semiconductor structure 402 such that light strikes light valve 406 prior to luminescent ceramic 408. Light valve 406 may be separated from the surface of the semiconductor structure 402 including photonic crystal 404 by, for example, an air gap 410. For example, a structure may be disposed between light valve 406 and semiconductor structure 402 to maintain gap 410. Alternatively, light valve 406 and luminescent ceramic 408 may be connected to a first package element, for example a cover or lens, and semiconductor structure 402 and host 400 may be connected to a second package element, for example a mount, such that when the two package elements are connected together, gap 410 is maintained between light valve 406 and semiconductor structure 402. Light scattered back toward semiconductor structure 402 by luminescent ceramic 408 may be reflected by light valve 406, as illustrated by the photons 601A and 601B shown in Fig. 24.

In the device illustrated in Fig. 25, light valve 406 is connected to luminescent ceramic 408 as in Fig. 24. Light valve 406 is connected to the photonic crystal surface of semiconductor structure 402 by a layer of an adhesive 412. Adhesive 412 may be, for example, a layer of silicone with a thickness on the order of microns, for example about 3 microns. The silicone may be selected to have a particular index of refraction such that adhesive 412 either causes a desired change in the radiation pattern emitted from the semiconductor structure, or does not significantly alter the radiation pattern. For example, a III-nitride structure 402 may have an index of refraction of about 2.4. A photonic crystal 404 formed in the structure may have an index of refraction of about 2.0. Adhesive 412 may be selected to have an index of refraction of between 1.3 and 1.7. In some embodiments, adhesive 412 at least partially fills holes 404; in other embodiments, it does not. In some embodiments, adhesive layer 412 is kept thin (for example, less than 1 micron) to minimize any effect on the radiation pattern.

An optional reflector 409, shown in Fig. 25, may be disposed over luminescent ceramic 408 in the devices shown in Figs. 24 and 25. Reflector 409 prevents light from escaping through the top of the device. Reflector 409 and light valve 406 may create a waveguide such that light may only exit the device through the sides of luminescent ceramic 408, resulting in a side-emitting device. Reflector 409 may be specular or diffusing. Examples of suitable specular reflectors include a DBR comprised of layers of organic or inorganic materials such as titanium oxide, a layer of aluminum, silver, or other reflective metal, or a combination of DBR and metal layers. Examples of suitable diffusing reflectors include a metal deposited on a roughened surface or a diffusing material such as a suitable white paint. Other suitable reflectors include a dichroic filter as described above, or a photonic crystal formed in the top surface of luminescent ceramic 408.

In the device illustrated in Fig. 26, a light valve 406 and luminescent ceramic 408 are spaced apart from semiconductor structure 402 as illustrated in Fig. 24. Light valve 406 and semiconductor structure 402 may behave as described above in reference to Fig. 24. A lens 414 may be mounted above luminescent ceramic 408. The sides of lens 414 reflect incident light, which eventually escapes through the top 415, as illustrated by the rays shown in Fig. 26. Lens 414 reduces the emitting area of the device from a large area $A_1$ to a smaller area $A_2$. The total amount of light produced by the device may not change, but reducing the emitting area may result in a higher radiance device, since the radiance is a function of power divided by emitting area. The relationship between areas $A_1$ and $A_2$ in Fig. 26 is determined by the angles of input $\theta$ (defined in air) and the refractive index of the lens, n:

$$A_2 = \frac{A_1 \sin^2 \theta_1}{n^2}$$

Lens 414, also known as a dielectric concentrator, may be optimized for the radiation pattern emitted by the semiconductor structure. For example, tailoring the photonic crystal to emit light into a narrow radiation cone may reduce area $A_1$, which may increase the luminance in area $A_2$.

Lens 414 may be, for example, a glass lens, such that light reflects from the sides by total internal reflection or by reflecting from an optional reflective coating applied to the sides. Alternatively, lens 414 may include reflective sidewalls enclosing a space filled with air. Light may escape through an opening in the reflective sidewalls at the top. The top surface 415 of lens 414 may be textured or roughened to increase light extraction. Lens 414 may be connected to luminescent ceramic 408 by conventional adhesives such as epoxy or silicone.

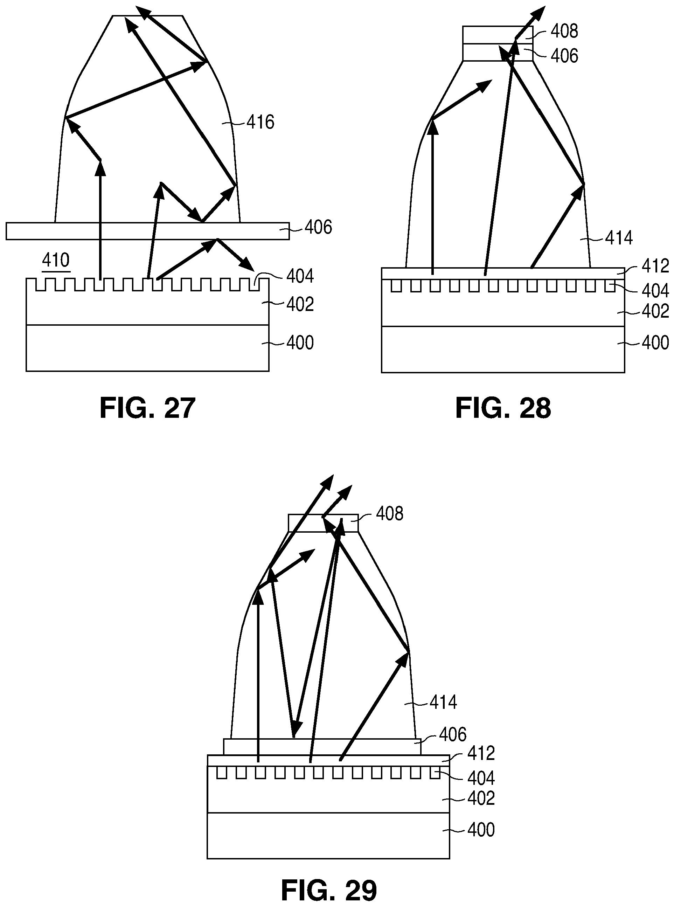

In the device illustrated in Fig. 27, a light valve 406 is spaced apart from semiconductor structure 402 as in Fig. 24. The luminescent ceramic 416 disposed over light valve 406 is shaped to emit light from a smaller area. Luminescent ceramic 416 both converts the wavelength and changes the emitting area of light emitted by semiconductor structure 402. Alternatively, luminescent ceramic 416 may be shaped into different shapes such as, for example, a dome lens, or as a Fresnel lens, to emit a desired radiation pattern. Luminescent ceramic 416 may be shaped into the desired shape before or after bonding to light valve 406.

In the device illustrated in Fig. 28, light valve 406 is bonded to luminescent ceramic 408. The light valve and luminescent ceramic are spaced apart from the photonic crystal 404 in semiconductor structure 402 by a lens 414. Light emitted by semiconductor structure 402 is emitted into luminescent ceramic 408 from a smaller area via lens 414. Lens 414, which is described above in reference to Fig. 26, may be connected to semiconductor structure 402 by a high index adhesive, as described above in reference to Fig. 25.

In the device illustrated in Fig. 29, DBR 406 is spaced apart from luminescent ceramic 408 by a lens 414, as described above in reference to Fig. 26. DBR 406 may be bonded to the photonic crystal surface of semiconductor structure 402 by a high index adhesive, as described above in reference to Fig. 25.

The preferred optical system device in accordance with the present invention has a semiconductor light emitting device such as an LED, a light valve such as a dielectric stack, and a luminescent ceramic. In accordance with the present invention, the LED is configured to emit most of the light within a desired cone by including a photonic crystal. The luminescent ceramic wavelength converts at least some of the light emitted by the LED. The light valve passes most of the light emitted from the LED and reflects most of the converted light from the luminescent ceramic. The radiation pattern of the LED is tailored to the reflection and transmission characteristics of the light valve such that light is efficiently extracted from the LED into the luminescent ceramic, and converted light is efficiently reflected away from the LED. Though examples above refer to semiconductor devices that emit blue light, and luminescent ceramics that emit yellow, green, and/or red light, it is to be understood that the present invention extends to semiconductor structures and luminescent ceramics that emit any color from UV through IR, including any combinations that emit white or any color of monochromatic light. The transition from low to high transmission in the light valve is not limited to around 550 nm as illustrated in Fig. 33, but can occur at any wavelength from the UV through IR depending on the semiconductor emitting wavelength and the desired luminescent ceramic emitting wavelength. For increased radiance a lens can be used in combination reducing the emitting area of the system.

Having described the invention and its context in detail, those skilled in the art will appreciate that, given the present disclosure, modifications may be made to the invention. For example, different features of the different devices described above may be omitted or combined with features from other devices. The scope of the present invention is defined by the appended claims, in light of the above description with accompanying drawings.

## Claims

1.   A device comprising:

a semiconductor structure (402) comprising:

- a light emitting layer disposed between an n-type region and a p-type region; and
- a variation in refractive index formed within or on a surface of the semiconductor structure, wherein the variation in refractive index is a photonic crystal (404);

a ceramic layer (408) disposed in a path of light emitted by the light emitting layer, the ceramic layer (408) comprising a wavelength converting material; and a light valve (406) disposed between the semiconductor structure (402) and the ceramic layer (408), wherein the variation in refractive index is configured to emit light in a predetermined angular emission profile and wherein the light valve (406) is configured to transmit a majority of light emitted in the predetermined emission profile and incident on the light valve (406).

2.   The device of claim 1 wherein the ceramic layer (408) comprises a rigid agglomerate of phosphor particles.

3.   The device of claim 1 wherein a total thickness of semiconductor layers in the device is less than about 1 $\mu$m.

4.   The device of claim 1 wherein a surface of the ceramic layer (408) is textured.

5.   The device of claim 1 further comprising a host substrate (400), wherein the semiconductor structure (402) is attached to the host substrate (400) and the ceramic layer (408) is disposed proximate a surface of the semiconductor structure opposite the host substrate.

6.   The device of claim 1 wherein the light valve (406) comprises one of a dielectric stack, a distributed Bragg reflector, a dichroic filter, a two-dimensional photonic crystal, and a three-dimensional photonic crystal.

7.   The device of claim 1 wherein more than 60% of light escaping the semiconductor structure (402) is emitted into a cone 45° from a normal to a major surface of the semiconductor structure (402) and more than 90% of the light emitted into the 45° cone is transmitted by the light valve (406).

8. The device of claim 7 wherein less than 10% of the light emitted by the ceramic is transmitted by the light valve (406).

9. The device of claim 1 further comprising a dielectric concentrator (414) disposed in a path of light emitted by the light emitting layer.

10. The device of claim 9 wherein the dielectric concentrator, (414) is a glass lens.

11. The device of claim 9 wherein the variation in refractive index is configured to emit light in a predetermined angular emission profile and wherein the dielectric concentrator (414) is configured such that a majority of light emitted in the predetermined emission profile is emitted into the dielectric concentrator.

12. The device of claim 1 further comprising a reflective layer (409), wherein the ceramic layer (408) is disposed between the reflective layer and the semiconductor structure (402).

**Patentansprüche**

1. Vorrichtung, die umfasst:

   eine Halbleiterstruktur (402), die umfasst:

   - eine lichtemittierende Schicht, die zwischen einer n-Typ-Region und einer p-Typ-Region angeordnet ist; und
   - eine Brechungsindexabweichung, die innerhalb oder auf einer Oberfläche der Halbleiterstruktur gebildet ist, wobei die Brechungsindexabweichung ein photonischer Kristall (404) ist;

   eine Keramikschicht (408), die in einem Weg von Licht angeordnet ist, das von der lichtemittierenden Schicht emittiert wird, wobei die Keramikschicht (408) ein Wellenlängenumwandlungsmaterial umfasst; und
   ein Lichtventil (406), das zwischen der Halbleiterstruktur (402) und der Keramikschicht (408) angeordnet ist, wobei die Brechungsindexabweichung so konfiguriert ist, dass sie Licht in einem vordefinierten Winkelemissionsprofil emittiert, und wobei das Lichtventil (406) so konfiguriert ist, dass es einen Großteil von Licht, das im vordefinierten Emissionsprofil emittiert wird und auf das Lichtventil (406) einfällt, überträgt.

2. Vorrichtung nach Anspruch 1, wobei die Keramikschicht (408) ein starres Agglomerat von Phosphorpartikeln umfasst.

3. Vorrichtung nach Anspruch 1, wobei die Gesamtdicke von Halbleiterschichten in der Vorrichtung weniger als ungefähr 1 $\mu$m beträgt.

4. Vorrichtung nach Anspruch 1, wobei eine Oberfläche der Keramikschicht (408) texturiert ist.

5. Vorrichtung nach Anspruch 1, die ferner ein Host-Substrat (400) umfasst, wobei die Halbleiterstruktur (402) am Host-Substrat (400) angebracht ist und die Keramikschicht (408) proximal einer Oberfläche der Halbleiterstruktur dem Host-Substrat gegenüberliegend angeordnet ist.

6. Vorrichtung nach Anspruch 1, wobei das Lichtventil (406) eines von einem dielektrischen Stapel, einem Bragg-Spiegel, einem dichroitischen Filter, einem zweidimensionalen photonischen Kristall und einem dreidimensionalen photonischen Kristall ist.

7. Vorrichtung nach Anspruch 1, wobei mehr als 60 % von Licht, das aus der Halbleiterstruktur (402) austritt, in einen Kegel 45° von einer Normalen zu einer Hauptoberfläche der Halbleiterstruktur (402) emittiert werden und mehr als 90 % des Lichts, das in den 45°-Kegel emittiert wird, vom Lichtventil (406) übertragen wird.

8. Vorrichtung nach Anspruch 7, wobei weniger als 10 % des Lichts, das von der Keramik emittiert wird, vom Lichtventil (406) übertragen werden.

**9.** Vorrichtung nach Anspruch 1, die ferner einen dielektrischen Konzentrator (414) umfasst, der in einem Weg von Licht angeordnet ist, das von der lichtemittierenden Schicht emittiert wird.

**10.** Vorrichtung nach Anspruch 9, wobei der dielektrische Konzentrator (414) eine Glaslinse ist.

**11.** Vorrichtung nach Anspruch 9, wobei die Brechungsindexabweichung so konfiguriert ist, dass sie Licht in einem vordefinierten Winkelemissionsprofil emittiert, und wobei der dielektrische Konzentrator (414) so konfiguriert ist, dass ein Großteil von Licht, das im vordefinierten Emissionsprofil emittiert wird, in den dielektrischen Konzentrator emittiert wird.

**12.** Vorrichtung nach Anspruch 1, die ferner eine reflektierende Schicht (409) umfasst, wobei die Keramikschicht (408) zwischen der reflektierenden Schicht und der Halbleiterstruktur (402) angeordnet ist.


**Revendications**

**1.** Dispositif comprenant :

une structure semi-conductrice (402) comprenant :

- une couche d'émission de lumière disposée entre une région de type n et une région de type p ; et
- une variation d'indice de réfraction formée dans ou sur une surface de la structure semi-conductrice, dans lequel la variation d'indice de réfraction est un cristal photonique (404) ;

une couche de céramique (408) disposée dans un trajet de la lumière émise par la couche d'émission de lumière, la couche de céramique (408) comprenant un matériau de conversion de longueur d'onde ; et
une valve de lumière (406) disposée entre la structure semi-conductrice (402) et la couche de céramique (408), dans lequel la variation d'indice de réfraction est configurée pour émettre une lumière dans un profil d'émission angulaire prédéterminé, et dans lequel la valve de lumière (406) est configurée pour transmettre une majeure partie de la lumière émise dans le profil d'émission prédéterminé et qui frappe la valve de lumière (406).

**2.** Dispositif selon la revendication 1, dans lequel la couche de céramique (408) comprend un agglomérat rigide de particules de phosphore.

**3.** Dispositif selon la revendication 1, dans lequel une épaisseur totale des couches semi-conductrices dans le dispositif est inférieure à environ 1 $\mu$m.

**4.** Dispositif selon la revendication 1, dans lequel une surface de la couche de céramique (408) est texturée.

**5.** Dispositif selon la revendication 1, comprenant en outre un substrat hôte (400), dans lequel la structure semi-conductrice (402) est attachée au substrat hôte (400) et la couche de céramique (408) est disposée à proximité d'une surface de la structure semi-conductrice à l'opposé du substrat hôte.

**6.** Dispositif selon la revendication 1, dans lequel la valve de lumière (406) comprend l'un d'une pile diélectrique, d'un réflecteur de Bragg réparti, d'un filtre dichroïque, d'un cristal photonique bidimensionnel et d'un cristal photonique tridimensionnel.

**7.** Dispositif selon la revendication 1, dans lequel plus de 60 % de la lumière s'échappant de la structure semi-conductrice (402) est émise dans un cône de 45° par rapport à une normale à une surface majeure de la structure semi-conductrice (402) et plus de 90 % de la lumière émise dans le cône de 45° est transmise par la valve de lumière (406).

**8.** Dispositif selon la revendication 7, dans lequel moins de 10 % de la lumière émise par la céramique est transmise par la valve de lumière (406).

**9.** Dispositif selon la revendication 1, comprenant en outre un concentrateur diélectrique (414) disposé dans un trajet de la lumière émise par la couche d'émission de lumière.

**10.** Dispositif selon la revendication 9, dans lequel le concentrateur diélectrique (414) est une lentille de verre.

**11.** Dispositif selon la revendication 9, dans lequel la variation d'indice de réfraction est configurée pour émettre une lumière dans un profil d'émission angulaire prédéterminé, et dans lequel le concentrateur diélectrique (414) est configuré de sorte qu'une majeure partie de la lumière émise dans le profil d'émission prédéterminé soit émise dans le concentrateur diélectrique.

**12.** Dispositif selon la revendication 1, comprenant en outre une couche réfléchissante (409), dans lequel la couche de céramique (408) est disposée entre la couche réfléchissante et la structure semi-conductrice (402).

10

26

24

16

20

12

22

14

18

FIG. 1
(PRIOR ART)

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

**FIG. 12A**   **FIG. 12B**

**FIG. 12C**   **FIG. 12D**

**FIG. 13**

```
                                                                    ┌─ 31
┌──────────────────────────────────────────────────────────┐
│     GROW EPITAXIAL LAYERS ON GROWTH SUBSTRATE            │
└──────────────────────────────────────────────────────────┘
                            │
                            ▼                                 ┌─ 33
┌──────────────────────────────────────────────────────────┐
│     ATTACH EPITAXIAL LAYERS TO HOST SUBSTRATE           │
└──────────────────────────────────────────────────────────┘
                            │
                            ▼                                 ┌─ 35
┌──────────────────────────────────────────────────────────┐
│            REMOVE GROWTH SUBSTRATE                        │
└──────────────────────────────────────────────────────────┘
                            │
                            ▼                                 ┌─ 37
┌──────────────────────────────────────────────────────────┐
│               THIN EPITAXIAL LAYERS                      │
└──────────────────────────────────────────────────────────┘
                            │
                            ▼                                 ┌─ 39
┌──────────────────────────────────────────────────────────┐
│              FORM PHOTONIC CRYSTAL                       │
└──────────────────────────────────────────────────────────┘
```

## FIG. 14

## FIG. 15

88

80

85

62

64A

64B

86

66

68

89

**FIG. 16**

700

87

80

85

85

62

64

86

66

68

**FIG. 17**

**FIG. 18**

$$2GaN + 60H^- + 6e^+ = 2Ga(OH)_3 + N_2$$

**FIG. 19**

**FIG. 20**

**FIG. 22**

**FIG. 21**

108

80

**FIG. 23A**

116
112
310
108

80

**FIG. 23B**

FIG. 24

FIG. 25

FIG. 26

**FIG. 27**

**FIG. 28**

**FIG. 29**

Transmission of new wide angle coating (0 to 80 degrees)

**FIG. 30**

EP 2 176 892 B1

500

402

**FIG. 31**

90°

402

**FIG. 32**

**FIG. 33**

**FIG. 34**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 86117204 A, Gerd O. Mueller
- US 20050269582 A1
- US 6351069 B
- US 6630691 B
- US 6696703 B
- US 6576488 B
- US 6650044 B
- US 20040145308 A1
- US 20040206972 A1
- US 20050205883 A1
- US 20050224826 A1
- US 6351069 B1
- US 09660317 B
- US 7053419 B1
- US 09880204 B
- US 7064355 B2
- US 6642618 B
- US 6630692 B, Goetz
- US 10804810 B
- US 10785616 B
- US 20050184638 A1